# EUROPÄISCHE PATENTSCHRIFT

(11) **EP 3 824 303 B1**
(45) Veröffentlichungstag und Bekanntmachung des Hinweises auf die Patenterteilung: **10.08.2022**
(21) Anmeldenummer: 19745968.8
(22) Anmeldetag: 04.06.2019
(51) Int. Cl.: H02P 1/04, H02P 23/14, H02P 23/04, H02P 29/024, G01R 31/34

(54) **VERFAHREN ZUM BEWERTEN EINER BETRIEBSBEREITSCHAFT EINES ELEKTROMOTORS SOWIE ELEKTROMOTOR UND VENTILATOR**
METHOD FOR EVALUATING THE OPERATIONAL READINESS OF AN ELECTRIC MOTOR, ELECTRIC MOTOR, AND VENTILATOR
PROCÉDÉ D'ÉVALUATION DE LA DISPONIBILITÉ OPÉRATIONNELLE D'UN MOTEUR ÉLECTRIQUE ET MOTEUR ÉLECTRIQUE ET VENTILATEUR

(30) Priorität: 17.07.2018 DE 102018211850
(43) Veröffentlichungstag der Anmeldung: 26.05.2021
(73) Patentinhaber: ZIEHL-ABEGG SE, 74653 Künzelsau (DE)
(72) Erfinder: SCHMEZER, Joachim, 74676 Niedernhall (DE)
(74) Vertreter: Ullrich & Naumann PartG mbB
(86) Internationale Anmeldenummer: PCT/DE2019/200059
(87) Internationale Veröffentlichungsnummer: WO 2020/015798

(56) Entgegenhaltungen:
- WO-A1-02/089305
- DE-A1-102008 001 714
- DE-U1-202017 100 915
- US-A- 6 100 656
- US-A1- 2013 106 335

## Beschreibung

Die Erfindung betrifft ein Verfahren zum Bewerten einer Betriebsbereitschaft eines Elektromotors, insbesondere eines Elektromotors eines Ventilators, vorzugsweise während einer Erstinbetriebnahme. Die Erfindung betrifft ferner einen Elektromotor sowie einen Ventilator.

Elektromotoren sind während ihres Betriebs unterschiedlichsten Arten von Schwingungen ausgesetzt. Diese Schwingungen können durch den Elektromotor selbst, durch die angetriebene Last oder durch die Umgebung, in der der Elektromotor installiert ist, entstehen. Wenn der Elektromotor beispielsweise Bestandteil eines Ventilators ist, so kann eine Unwucht des Laufrads eine Vibration erzeugen. Zudem kann ein nicht-gleichförmiges Antriebsmoment, das beispielsweise durch eine pulsierende Zwischenkreisgleichspannung entstehen kann, die Schwingungen weiter verstärken. Wenn der Ventilator in einer Industrieumgebung eingebaut ist, die Vibrationen an den Ventilator überträgt, ist der Ventilator weiteren Schwingungen ausgesetzt.

Motoren bzw. Ventilatoren werden üblicherweise vor der Auslieferung an den Kunden bzw. vor Einbau in ein Gehäuse dynamisch ausgewuchtet, indem unsymmetrische Gewichtsverteilungen oder sonstige schwingungserzeugende Umstände reduziert werden. Allerdings kann es bereits beim Einbau in ein Gehäuse, beim Transport zum Kunden, beim Aufbau in einer Kundenapplikation oder beim Endkunden zu Beschädigungen kommen, die die Wuchtgüte beeinträchtigen. Wenn ein Ventilator in Umgebungen mit anhaftender Verschmutzung, wie beispielsweise in der Landwirtschaft oder bei stark korrosiven Umgebungsbedingungen, betrieben wird, wird über die Lebensdauer des Ventilators ebenfalls die Wuchtgüte beeinträchtigt.

Unwuchten führen zu verstärkten Schwingungen, die wiederum die Bestandteile des Elektromotors sehr stark belasten. So werden beispielsweise die Lager durch Schwingungen erheblich stärker beansprucht, als dies bei einem weniger schwingenden System der Fall wäre. Andererseits belasten die Schwingungen Elektroniken, die in den Elektromotor integriert sind. Dies kann zu einem Lösen von Verlötungen, einem Zerstören von Bauelementen oder gar einem Bruch von Leiterplatten führen. Insgesamt kann ein hohes Maß an Schwingungen dazu führen, dass die Lebensdauer des Elektromotors und/oder seiner Komponenten deutlich reduziert wird.

In der EP 2 972 431 B1 ist ein Elektromotor mit Funktionsüberwachung der Motorlager offenbart. Hierzu ist ein Schwingungssensor am Statorflansch auf dessen vom Rotor abgewandten Seite befestigt und misst Vibrationen des Elektromotors. Auf diese Weise kann erkannt werden, wenn Probleme mit dem Lager des Elektromotors entstehen. Allerdings werden hierbei Probleme erst dann erkannt, wenn sich diese bereits in einem relativ fortgeschrittenen Stadium befinden. Weiterer relevanter Stand der Technik ist in WO 02/089305 A1, DE 20 2017 100915 U1, DE 10 2008 001714 A1, US 6 100 656 A und US 2013/106335 A1 offenbart.

Der vorliegenden Erfindung liegt daher die Aufgabe zugrunde, ein Verfahren, einen Elektromotor und einen Ventilator der eingangs genannten Art derart auszugestalten und weiterzubilden, dass ein sicherer und zuverlässiger Betrieb gewährleistet werden kann.

Erfindungsgemäß wird die voranstehende Aufgabe durch die Merkmale des Anspruchs 1 gelöst. Danach umfasst das in Rede stehende Verfahren die Schritte:
Initiieren eines Hochlaufvorgangs des Elektromotors, wobei die Drehzahl während des Hochlaufvorgangs in mehreren Drehzahlstufen geändert wird.
Erzeugen mindestens eines Messwerts durch jeweiliges Messen einer physikalischen Größe mit einem Sensor des Elektromotors bei mindestens einer der Drehzahlstufen,
Laden mindestens eines Parameterdatums aus einem Parameterspeicher des Elektromotors, wobei das mindestens eine Parameterdatum zu dem erzeugten mindestens einen Messwerts korrespondiert, und
Bewerten des mindestens einen Messwerts für mindestens eine der Drehzahlstufen unter Verwendung des geladenen mindestens einen Parameterdatums. Hinsichtlich des Elektromotors ist die anstehende Aufgabe durch die Merkmale des Anspruchs 15 gelöst. Danach umfasst der Elektromotor, der vorzugsweise zur Durchführung des erfindungsgemäßen Verfahrens ausgebildet ist, einen Parameterspeicher und eine Schnittstelle zur Übertragung von Parameterdaten, wobei der Parameterspeicher zum Speichern von über die Schnittstelle während eines Parametriervorgangs übertragenen Parameterdaten ausgebildet ist.

Hinsichtlich eines Ventilators ist die voranstehende Aufgabe durch die Merkmale des Anspruchs 17 gelöst, wonach der Ventilator einen erfindungsgemäßen Elektromotor und ein Laufrad umfasst, wobei das Laufrad mit einem Rotor des Elektromotors verbunden ist.

In erfindungsgemäßer Weise ist zunächst erkannt worden, dass sich in vielen Fällen aufkommende Probleme bereits sehr frühzeitig ankündigen. So kann bereits bei einer Erstinbetriebnahme eines Elektromotors abgeschätzt werden, ob und wie lange ein Elektromotor bei den aktuellen Betriebsbedingungen betrieben werden kann. Daher wird erfindungsgemäß die Betriebsbereitschaft eines Elektromotors bewertet und dies vorzugsweise bereits bei einer ersten Inbetriebnahme des Elektromotors nach Lieferung und Einbau in der Betriebsumgebung.

Damit eine derartige Überprüfung der Betriebsbereitschaft des Elektromotors möglich ist, sind dem Elektromotor erfindungsgemäß Parameterdaten zur Verfügung gestellt, die eine Bewertung des Betriebs des Elektromotors zulassen. Diese Parameterdaten gehen über die sonst üblicherweise bei dem Elektromotor vorhandenen Parameter, wie beispielsweise eine Nenndrehzahl oder ein Nennmoment, hinaus. Denn die Parameterdaten können weitreichende Informationen über die Konstruktion des Elektromotors und seine Einbau- und Betriebsbedingungen angeben. So können die Parameterdaten Referenzwerte, konstruktive Informationen über den Elektromotor, konstruktive Informationen über eine durch den Elektromotor betriebene Last (beispielsweise das Laufrad eines Ventilators), Kennlinien des Elektromotors, Kennlinien von Komponenten und/oder Informationen über das Betriebsverhalten des Elektromotors umfassen. Diese Parameterdaten werden bei dem erfindungsgemäßen Verfahren zum Bewerten der Betriebsbereitschaft des Elektromotors genutzt, um erzeugte Messwerte zu bewerten. Die Bewertung der Messwerte liefert wiederum Rückschlüsse, ob der Elektromotor insgesamt betriebsbereit ist.

Erfindungsgemäß wird zunächst ein Hochlaufvorgang des Elektromotors initiiert. Während des Hochlaufvorgangs wird die Drehzahl in mehreren Drehzahlstufen geändert. Dabei ist es prinzipiell nicht von Bedeutung, wie die Drehzahl geändert wird. Die Drehzahl kann aufsteigend oder absteigend geändert werden. Es ist sogar denkbar, dass die Drehzahl relativ beliebig zwischen verschieden großen Werten springt. Wichtig ist lediglich, dass der Elektromotor bei mehreren Drehzahlen betrieben wird, um das Verhalten des Elektromotors bei unterschiedlichen Drehzahlen bewerten zu können. Da sich der Elektromotor bei Anlegen einer Versorgungsspannung üblicherweise in einem Stillstand befinden und damit eine Drehzahl gleich Null vorliegen wird, wird die Drehzahl vorzugsweise von einer unteren Drehzahl zu einer oberen Drehzahl geändert. Hierbei ist die untere Drehzahl vorzugsweise durch eine Drehzahl gleich Null - Stillstand des Elektromotors - und die obere Drehzahl vorzugsweise durch eine Nenndrehzahl des Elektromotors gebildet. Bei der Veränderung der Drehzahl können die Drehzahlstufen äquidistant zueinander sein. Es ist aber auch möglich, dass die Abstände zwischen Drehzahlstufen nicht weiter miteinander korrelieren. Zur Vermeidung einer unnötigen Belastung des Elektromotors durch einen Wechsel von einer Drehzahl zu einer nächsten Drehzahl bietet es sich an, wenn die Drehzahl kontinuierlich oder quasikontinuierlich zwischen den Drehzahlstufen geändert wird.

In einem weiteren Schritt wird mindestens ein Messwert erzeugt. Der Messwert bzw. jeder der Messwerte entsteht dabei durch jeweiliges Messen einer physikalischen Größe mit einem Sensor des Elektromotors bei mindestens einer der Drehzahlstufen. Dies bedeutet, dass bei mehreren Messwerten eine physikalische Größe mit einem Sensor bei mehreren Drehzahlstufen oder eine physikalische Größe mit mehreren Sensoren bei einer oder mehreren Drehzahlen oder mehrere physikalische Größen mit mehreren Sensoren bei einer oder mehreren Drehzahlstufen gemessen werden. Welche der physikalischen Größen, die bei dem Elektromotor prinzipiell messbar sind, in diesem Schritt gemessen werden, hängt von der Art der Bewertung der Betriebsbereitschaft ab. Die jeweiligen physikalischen Größen werden dabei durch mindestens einen Sensor des Elektromotors erfasst. Ein "Sensor des Elektromotors" kann jeder Sensor sein, der in den Elektromotor oder in einer Elektronik des Elektromotors integriert ist. Dies kann prinzipiell auch einen Sensor einschließen, der in einer außen an dem Elektromotor befestigten Motorelektronik integriert ist, beispielsweise eine an dem Motorgehäuse angeflanschte Motorelektronik.

In einem weiteren Schritt wird mindestens ein Parameterdatum aus einem Parameterspeicher des Elektromotors geladen. Die Parameterdaten werden dabei vorzugsweise während eines Parametriervorgangs an den Parameterspeicher übertragen und dort abgespeichert. Auf diesen Parametriervorgang wird nachfolgend noch genauer eingegangen. Hinsichtlich des mindestens einen Parameterdatums ist von Bedeutung, dass das jeweils geladene Parameterdatum unmittelbar oder mittelbar mit dem jeweils erzeugten Messwert korrespondiert. Ein Parameterdatum kann beispielsweise unmittelbar mit dem Messwert korrespondieren, wenn der Messwert eine Schwingung des Elektromotors angibt und das Parameterdatum eine maximal zulässige Schwingung. Hierbei dürfte sich das Parameterdatum meist auf dieselbe physikalische Größe beziehen wie der Messwert. Ein mittelbar korrespondierendes Parameterdatum kann beispielsweise durch eine konstruktive Information über den Elektromotor oder Abmessungen des Elektromotors gebildet sein. Derartige Parameterdaten können einen mittelbaren Einfluss auf eine Messgröße haben. So können beispielsweise Abmessungen des Elektromotors Einfluss auf Schwingungen des Elektromotors haben, so dass dieses Parameterdatum mittelbar zu einem Schwingungsmesswert korrespondiert. Durch Wahl entsprechend korrespondierender Parameterdaten kann sichergestellt werden, dass eine Bewertung des erzeugten Messwerts unter Verwendung des geladenen Parameterdatums möglich ist.

Unter Verwendung des geladenen mindestens einen Parameterdatums wird in einem weiteren Schritt eine Bewertung des mindestens einen Messwerts vorgenommen. Diese Bewertung kann beispielsweise das Einhalten eines Grenzwerts umfassen. Denkbar ist jedoch auch eine Überprüfung, ob der erzeugte Messwert zu den in dem Parameterdatum angegebenen geometrischen Informationen passen kann oder ob beispielsweise eine nachträgliche Veränderung des Elektromotors oder der mit dem Elektromotor verbundenen Last vorgenommen worden ist oder ob der Elektromotor während des Transports beschädigt worden ist.

Die "physikalische Größe" kann durch unterschiedliche Größen innerhalb des Elektromotors gebildet sein. Dies kann prinzipiell auch eine Spannung an einer oder einen Strom durch eine Spule des Stators oder des Rotors umfassen. Vorzugsweise beziehen sich diese physikalischen Größen jedoch auf mechanische Größen und/ oder magnetische Größen und/oder eine Temperatur. Beispielhaft für derartige physikalische Größen, jedoch nicht auf diese beschränkt, sei auf die Drehzahl des Rotors des Elektromotors, Schwingungen, Beschleunigungen, Druckunterschiede und/oder Neigungswinkel verwiesen. Je nach gemessener physikalischer Größe wird auch der jeweilige Sensor ausgebildet sein. So können beispielsweise Beschleunigungen mit einem Beschleunigungssensor, Druckunterschiede mit einem Drucksensor oder einem Mikrofon und Temperaturen mit einem Temperatursensor erfasst werden. Es ist auch denkbar, dass mehrere Sensoren eine physikalische Größe erfassen, beispielsweise an verschiedenen Stellen des Elektromotors.

Die Bedeutung des Begriffs "Betriebsbereitschaft" des Elektromotors wird von verschiedenen Bedingungen abhängen. So kann der Elektromotor beispielsweise in einer nicht zulässigen räumlichen Orientierung eingebaut worden sein, die zu einer zu hohen Lagerbeanspruchung oder einer zu hohen Beanspruchung des Rotors oder der mit dem Rotor verbundenen Last führt. Dadurch kann die Lebensdauer des Elektromotors erheblich reduziert sein. In diesem Fall kann der Elektromotor zwar prinzipiell betrieben werden, dennoch muss wohl eine generelle Betriebsbereitschaft abgesprochen werden. Auch wäre denkbar, dass der Elektromotor während dessen Betrieb einer sehr hohen Vibrationsbeanspruchung ausgesetzt ist, die ebenfalls einen sicheren Betrieb nicht gewährleistet. Eine mangelnde Betriebsbereitschaft könnte aber auch dann vorliegen, wenn der Elektromotor Teil eines Ventilators ist und an dem Laufrad Strömungsabrisse zu verzeichnen sind. Dies spricht für eine ungünstige Dimensionierung des Ventilators oder der Einsatzumgebung und kann bis hin zu Rissen an den Flügeln des Ventilators führen. Auch hier kann eine Betriebsbereitschaft verneint werden.

Diese kurze und beispielhafte Aufzählung zeigt, was alles unter dem Begriff "Betriebsbereitschaft" verstanden werden kann.

Zur Vermeidung von undefinierten Schwingungszuständen während des Messens der physikalischen Größe bietet es sich an, wenn die Messung/en in einem weitgehend eingeschwungenen System durchgeführt wird/werden. Daher wird in einer Weiterbildung des Verfahrens vorzugsweise vor dem Erzeugen des mindestens einen Messwerts überprüft, ob die Drehzahl des Elektromotors eine eingestellte Drehzahlstufe erreicht hat oder ob sich die Drehzahl noch in Richtung der eingestellten Drehzahlstufe bewegt. Dies bedeutet, dass beispielsweise bei Vorgabe einer eingestellten Drehzahlstufe von 97 Umdrehungen/min überprüft wird, ob die Drehzahl tatsächlich bei 97 Umdrehungen/min liegt oder die Drehzahl des Elektromotors aktuell noch in Richtung der eingestellten Drehzahlstufe geändert wird. Das Erreichen einer eingestellten Drehzahlstufe gewährleistet zum einen, dass geladene drehzahlabhängige Parameterdaten auch tatsächlich zu einer zuverlässigen Bewertung eines Messwerts genutzt werden können. Zum anderen befindet sich dann der Elektromotor üblicherweise nicht mehr in einem Zwischenzustand, im dem Messwerte durch Einschwingvorgänge beeinträchtigt sind.

In einer Weiterbildung wird bei dem Schritt des Bewertens des mindestens einen Messwerts überprüft, ob eine vorgegebene Randbedingung eingehalten wird. Eine derartige Randbedingung kann beispielsweise ein Grenzwert sein, über dem ein sicherer Betrieb des Elektromotors nicht gewährleistet werden kann. Wenn eine derartige oder ähnliche Randbedingung nicht eingehalten ist, kann eine Warnmeldung ausgegeben und/oder das Verfahren abgebrochen werden. Die Warnmeldung kann dabei auf verschiedenste Weisen ausgegeben werden. Denkbar ist beispielsweise, dass eine LED (Licht-emittierende Diode) aufleuchtet und dadurch eine Störung anzeigt. Da insbesondere bei einer Erstinbetriebnahme der Elektromotor mit einem Programmiergerät oder einem Steuercomputer verbunden sein dürfte, kann eine derartige Warnmeldung auch an dieses Programmiergerät bzw. diesen Steuercomputer ausgegeben werden. In diesem Fall kann die einrichtende Person unmittelbar auf die Warnmeldung reagieren.

In einer anderen Weiterbildung umfasst das Verfahren zusätzlich einen Schritt der Abschätzung einer Lagerlebensdauer, wobei bei der Abschätzung der Lagerlebensdauer mehrere Parameterdaten geladen und/oder mehrere Messwerte gemessen und miteinander kombiniert werden. Insbesondere bei einer Erstinbetriebnahme kann die abgeschätzte Lagerlebensdauer dann als Initialwert in einem Speicher, beispielsweise dem Parameterspeicher, abgelegt werden. Dabei kann davon ausgegangen werden, dass der Elektromotor unter den aktuell vorliegenden Betriebsbedingungen während der gesamten Lagerlebensdauer betrieben wird. Diese Betriebsbedingungen können beispielsweise eine Betriebstemperatur, eine Schwingungsbeanspruchung und/oder eine Einbaulage des Elektromotors umfassen. Ergänzend kann ein zunehmender Verschleiß von Bestandteilen des Elektromotors bei der Abschätzung der Lagerlebensdauer berücksichtigt werden. So wird ein Elektromotor mit zunehmendem Verschleiß der Lager mehr Schwingungen erzeugen als ein fabrikneuer Elektromotor. Die zunehmende Schwingungsbeanspruchung führt wiederum zu einer Reduzierung der Lagerlebensdauer. Dies kann bei der Abschätzung der Lagerlebensdauer mit berücksichtigt werden, da das Verhalten bei zunehmendem Verschleiß relativ gut abschätzbar ist.

In einer anderen Weiterbildung werden der Schritt des Erzeugens mindestens eines Messwerts, der Schritt des Ladens mindestens eines Parameterdatums und der Schritt des Bewertens des mindestens einen Messwerts für jede der mehreren Drehzahlstufen durchgeführt. Auf diese Weise kann ein umfassendes Bild über die Betriebsbereitschaft des Elektromotors erzeugt werden. Dabei muss die Reihenfolge nicht zwingend für alle Schritte und alle Messwerte eingehalten werden. So ist es denkbar, dass zunächst alle Messwerte für alle Drehzahlstufen erfasst werden und erst danach eine Bewertung der Messwerte erfolgt. Da einzelne Messwerte, wie beispielsweise eine Schwingungsbeanspruchung, allerdings auch für das Einstellen der nächsten Drehzahlstufe relevant sein kann, können auch einzelne oder alle Messwerte unmittelbar nach der Erfassung bewertet werden.

Bei dem Schritt des Erzeugens des mindestens einen Messwerts kann eine Beschleunigung und/oder eine Geschwindigkeit einer Schwingung des Elektromotors mittels eines Schwingungssensors des Elektromotors gemessen und daraus ein Schwingungswert erzeugt werden. Anordnungen, mit denen eine derartige Schwingungsmessung möglich ist, sind beispielsweise in der DE 10 2018 211 838 A1 und in der DE 10 2018 211 833 A1 offenbart, auf deren jeweiligen Inhalt hiermit ausdrücklich Bezug genommen wird.

Bei dem Erzeugen des Schwingungswerts kann eine Messung der Schwingungen auch bei einer Drehzahl gleich Null durchgeführt werden, was einem Stillstand des Elektromotors entspricht. Dies bedeutet, dass sich der Rotor relativ zu dem Stator und um die Rotorachse nicht oder allenfalls unwesentlich bewegt. Dadurch kann der Elektromotor selbst keine Schwingungen erzeugen, die durch den Schwingungssensor des Elektromotors gemessen werden können. Allerdings kann auf diese Weise überprüft werden, ob und in welchem Ausmaße Schwingungen der Einbauumgebung des Elektromotors in den Elektromotor eingekoppelt werden. Nicht selten sind diese eingekoppelten Schwingungen der Einbauumgebung derart erheblich, dass die zusätzlichen Schwingungen des Elektromotors während dessen Betriebs eine zu hohe Schwingungsbeanspruchung des Elektromotors ergeben. Durch eine Bewertung der Schwingungen bei einer Drehzahl von Null kann dieser unsichere Betrieb des Elektromotors bereits vor einer Betriebsaufnahme erkannt werden.

Unabhängig von der gewählten Drehzahlstufe kann bei dem Schritt des Ladens des mindestens einen Parameterdatums eine maximal zulässige Schwingung als ein mit dem Schwingungswert korrespondierendes Parameterdatum geladen werden. Die maximal zulässige Schwingung würde dann in dem Schritt des Bewertens des Messwerts mit dem erzeugten Schwingungswert verglichen. Auf diese Weise kann festgestellt werden, ob bei einer gegebenen Drehzahl derart große Schwingungen des Elektromotors vorhanden sind, dass ein sicherer Betrieb des Elektromotors nicht gewährleistet ist. In diesem Fall kann von einer Betriebsbereitschaft des Elektromotors nicht die Rede sein, da ein Betrieb des Elektromotors zu einer frühzeitigen Beschädigung des Elektromotors oder der von dem Elektromotor angetriebenen Last führen könnte.

Zusätzlich oder alternativ kann bei dem Schritt des Ladens des mindestens einen Parameterdatums ein Schwingungswert, der während einer Kalibrierungsmessung des Elektromotors, beispielsweise während dessen Endprüfung, erzeugt worden ist, für die aktuelle Drehzahl geladen werden. Dies bedeutet, dass die Parameterdaten Schwingungswerte aus einer Kalibrierungsmessung - nachfolgend auch als Kalibrierungswerte bezeichnet - bei unterschiedlichen Drehzahlen enthalten und dass ein Kalibrierungswert, der mit der aktuellen Drehzahl des Elektromotors korrespondiert, geladen und mit dem aktuell gemessenen Schwingungswert verglichen wird. Dabei sollten der Kalibrierungswert und der aktuell gemessene Schwingungswert nur unerheblich voneinander abweichen. Wenn die Abweichung über ein vorgegebenes Maß hinausgeht, kann auf das Vorliegen einer Beschädigung geschlossen werden.

In einer Verfeinerung dieser Ausgestaltung können Schwingungen der Einbauumgebung bei dem Vergleich des Kalibrierungswertes mit dem aktuell gemessenen Schwingungswert berücksichtigt werden. Dabei würden ein erster Schwingungswert während eines Stillstands des Elektromotors und ein zweiter Schwingungswert bei einer von Null verschiedenen Drehzahl bestimmt. Der erste Schwingungswert repräsentiert dabei die Schwingungen der Einbauumgebung. Der zweite Schwingungswert betrifft Schwingungen, die durch eine Überlagerung der Schwingungen der Einbauumgebung und der Schwingungen des Elektromotors entstehen. Bei der Bewertung des zweiten Schwingungswertes kann dann der erste Schwingungswert von dem zweiten Schwingungswert abgezogen und mit einem Kalibrierungswert verglichen werden. Wenn die Differenz des ersten und zweiten Schwingungswertes über ein vorgegebenes Maß von dem Kalibrierungswert abweicht, kann auf das Vorliegen einer Beschädigung geschlossen werden. Eine derartige Beschädigung kann beispielsweise durch einen unsachgemäßen Transport oder - wenn der Elektromotor Teil eines Ventilators ist - durch ein Verbiegen eines Flügels des Ventilators entstanden sein.

In einer anderen Ausgestaltung des Schrittes des Erzeugens des mindestens einen Messwerts, die ergänzend oder alternativ eingesetzt werden kann, kann die räumliche Orientierung des Elektromotors bestimmt werden. Ein derartiges Verfahren ist beispielsweise in der DE 10 2018 211 843 A1 offenbart, auf deren Inhalt hiermit ausdrücklich Bezug genommen wird.

Ein zu diesem Messwert korrespondierendes Parameterdatum kann einen zulässigen Bereich einer räumlichen Orientierung des Elektromotors umfassen. Ein derartiger zulässiger Bereich würde dann in dem Schritt des Ladens des mindestens einen Parameterdatums geladen werden und während des Schritts des Bewertens des Messwerts zur Überprüfung der Einbaulage des Elektromotors genutzt werden. Hierbei kann überprüft werden, ob die räumliche Orientierung des Elektromotors innerhalb des zulässigen Bereichs liegt. Der zulässige Bereich kann dabei einzelne diskrete Orientierungen umfassen. So kann beispielsweise das Parameterdatum angeben, dass lediglich eine horizontale Einbaulage zulässig ist. Da es schwierig sein dürfte, die Forderung einer absolut horizontalen Einbaulage einhalten zu können, bietet es sich auch bei diskreten räumlichen Orientierungen an, dass ein Orientierungsbereich angegeben wird. So könnte beispielsweise ein Winkelbereich von ± 2° zugelassen werden, wenn eine horizontale Einbaulage gefordert ist.

Ein erfindungsgemäßer Elektromotor, der vorzugsweise zum Durchführen des erfindungsgemäßen Verfahrens ausgebildet ist, weist einen Parameterspeicher und eine Schnittstelle zur Übertragung von Parameterdaten auf. Der Parameterspeicher ist zum Speichern von Parameterdaten ausgebildet. Die Schnittstelle ist derart mit dem Parameterspeicher verbunden, dass über die Schnittstelle übertragene Parameterdaten in dem Parameterspeicher abspeicherbar sind. Hierzu kann beispielsweise ein Mikroprozessor vorgesehen sein, der eine Kommunikation über die Schnittstelle steuert und über die Schnittstelle empfangene Parameterdaten in den Parameterspeicher ablegt. Dabei kann der Parameterspeicher als dedizierter Speicher ausgebildet sein, der lediglich Parameterdaten speichert. Da üblicherweise noch weitere Daten innerhalb einer Motorelektronik gespeichert werden müssen, kann der Parameterspeicher auch ein Teilbereich eines größeren Speichers sein. Dabei sollte der Parameterspeicher durch einen nicht-flüchtigen Speicher gebildet sein. Da die Parameterdaten üblicherweise fest mit dem Elektromotor verknüpft sind und sich daher die Parameterdaten während der Lebensdauer des Elektromotors nicht ändern dürften, kann der Parameterspeicher prinzipiell sogar als ein nicht-änderbarer Speicher ausgebildet sein. Vorzugsweise ist der Inhalt des nicht-flüchtigen Speichers jedoch änderbar. Lediglich beispielhaft, jedoch nicht auf diese beschränkt sei auf die Verwendung von Flash-Speicher, EEPROM (Electronically Erasable Programmable Read-Only Memory), NVRAM (Non-Volatile Random Access Memory) oder anderen Halbleiterspeichern verwiesen.

Ein System, in das Parameterdaten auf den Elektromotor übertragen und dort gespeichert werden können, ist beispielsweise in der DE 10 2018 211 846 A1 offenbart, auf deren Inhalt hiermit ebenso ausdrücklich Bezug genommen wird. Die dort übertragenen Parameterdaten sind Referenzwerte, die für die Beurteilung der Messwerte eines motorinternen Schwingungssensors genutzt werden können. Dieses System lässt sich jedoch auch zur Übertragung weiterer Parameterdaten nutzen.

Die in dem Parameterspeicher abgelegten Parameterdaten können zusätzlich in einer Datenbank abgelegt sein, die beispielsweise durch den Hersteller des Elektromotors betrieben werden kann. Dies ist insbesondere dann einfach möglich, wenn die Parameterdaten während einer Endprüfung und/oder einer Kalibrierungsmessung auf den Elektromotor übertragen werden. Ein Datensatz in einer derartigen Datenbank kann einen "digitalen Zwilling" des Elektromotors repräsentieren, in dem alle wesentlichen Informationen über den Elektromotor und/oder dessen Betriebsverhalten enthalten sind. Ein derartiges Datenbanksystem ist beispielsweise in der DE 10 2018 201 707 A1 beschrieben, auf deren Inhalt hiermit ausdrücklich Bezug genommen wird.

Wenn eine derartige Datenbank im Einsatz ist, können Ergebnisse aus dem erfindungsgemäßen Bewertungsverfahren in die Datenbank geladen werden. So ist es beispielsweise denkbar, dass in einen "digitalen Zwilling" Informationen über das Schwingungsverhalten der Einbauumgebung, die Einbaulage des Elektromotors, ein Initialwert für die Lagerlebensdauer oder Ergebnisse einer Bewertung von Messwerten ergänzt werden. Hierzu kann die Schnittstelle des Elektromotors genutzt werden. Diese zusätzlichen Informationen können über eine Weitbereichsschnittstelle zu der Datenbank übertragen werden. Es ist auch möglich, dass bei Verwendung eines Programmiergeräts oder eines Steuercomputers während einer Erstinbetriebnahme die zusätzlichen Informationen zunächst in dem Programmiergerät oder dem Steuercomputer gesammelt und anschließend an die Datenbank übertragen werden. Hierzu kann wiederum ein Weitbereichsnetzwerk genutzt werden oder es kann ein Massenspeicher, wie beispielsweise ein USB-Stick, zum Einsatz kommen. In letzterem Fall würden die in dem Massenspeicher abgelegten Informationen in einem weiteren Schritt in die Datenbank importiert.

Die Parameterdaten können prinzipiell verschiedenste Informationen umfassen, die den Elektromotor und eine mit dem Elektromotor (dauerhaft) verbundene Last beschreibt. Beispielhaft sei auf einen Schwerpunkt des Elektromotors oder Teile des Elektromotors und/oder eine Masse des Elektromotors oder Teile des Elektromotors und/oder Lageranstellkräfte und/oder Kenndaten des Lagers und/oder eine maximal zulässige Unwucht des Elektromotors und/oder geometrische Daten des Elektromotors und/oder einen zulässigen Bereich räumlicher Orientierungen des Elektromotors und/oder eine maximal zulässige Drehzahl des Elektromotors und/oder eine Kennlinie der magnetischen Anziehung zwischen Stator und Rotor des Elektromotors verwiesen.

"Lageranstellkräfte" bezeichnen dabei Axialkräfte, die auf das Lager wirken. Durch diese Kräfte kann gewährleistet werden, dass die Wälzkörper des Lagers, meist Kugeln, zwischen dem Innen- und dem Außenring des Lagers tatsächlich rollen und nicht zwischen den Ringen durchgleiten. Durch Rollen der Wälzkörper bleibt die Reibung bei Betrieb des Lagers gering. Wenn die Lageranstellkräfte allerdings zu groß sind, erhöht sich der Verschleiß des Lagers, was wiederum die Lebensdauer des Lagers reduziert. Damit unterstützt ein derartiges Parameterdatum die Abschätzung der Lagerlebensdauer.

"Kenndaten des Lagers" können beispielsweise Abmessungen des Lagers (Durchmesser des Außenrings, Durchmesser der Wälzkörper, Innendurchmesser des Innenrings, Breite des Lagers, etc.), Lagerspiel, Tragzahlen und/oder weitere Berechnungsfaktoren der Lager umfassen. Allerdings können hierunter auch Besonderheiten der Lagerung fallen, wie beispielsweise ob das Lager einen Deckring oder einen Nilosring aufweist oder welche Befettung das Lager verwendet ist. Derartige Kenndaten lassen sich meist dem Datenblatt des Lagers entnehmen. Die Kenndaten des Lagers können aber auch ein Fertigungsdatum des Lagers umfassen, was insbesondere für die Abschätzung der Lebensdauer des Schmiermittels von Bedeutung ist.

Der erfindungsgemäße Elektromotor kann Bestandteil eines Ventilators sein, wobei hierzu ein Laufrad mit einem Rotor des Elektromotors verbunden ist. Meist werden hierbei Laufrad und Elektromotor bereits während der Fertigung verbunden, so dass sehr genau bekannt ist, wie sich der Ventilator verhält. Insbesondere ist damit auch bekannt, welche Last - das Laufrad - durch den Elektromotor angetrieben wird und wie deren Eigenschaften sind. In diesem Fall können die Parameterdaten zusätzlich eine maximal zulässige Unwucht des Ventilators und/oder geometrische Daten des Laufrads und/oder Informationen über die Ausgestaltung des Laufrads und/oder eine Axialschub-Drehzahlkennlinie und/oder weitere Informationen über das Laufrad umfassen.

"Axialschub" bezeichnet dabei die Kraft auf die Flügel des Ventilators, die durch die Bewegung der Luft durch die Flügel entsteht. Der Axialschub hängt damit mit dem Luftdruck zusammen, der auf die Flügel wirkt. Der Axialschub ist dabei eine drehzahlabhängige Größe. Je größer der Axialschub ist, desto stärker werden die Lager in Längsrichtung der Welle belastet. Dies hat wiederum Auswirkungen auf die Lebensdauer der Lager.

Es gibt nun verschiedene Möglichkeiten, die Lehre der vorliegenden Erfindung in vorteilhafter Weise auszugestalten und weiterzubilden. Dazu ist einerseits auf die den nebengeordneten Ansprüchen nachgeordneten Ansprüche und andererseits auf die nachfolgende Erläuterung eines bevorzugten Ausführungsbeispiels der Erfindung anhand der Zeichnung zu verweisen. In Verbindung mit der Erläuterung des bevorzugten Ausführungsbeispiels der Erfindung anhand der Zeichnung werden auch im Allgemeinen bevorzugte Ausgestaltungen und Weiterbildungen der Lehre erläutert. In der Zeichnung zeigen
- Fig. 1: ein Blockdiagramm mit einem System aus einem Elektromotor und einer Prüfanlage, mit der Parameterdaten an einen Parameterspeicher übergeben werden können,
- Fig. 2: ein Ablaufdiagramm für eine Speicherung von Parameterdaten in einem Parameterspeicher und
- Fig. 3: ein Ablaufdiagramm eines Ausführungsbeispiels eines erfindungsgemäßen Verfahrens.

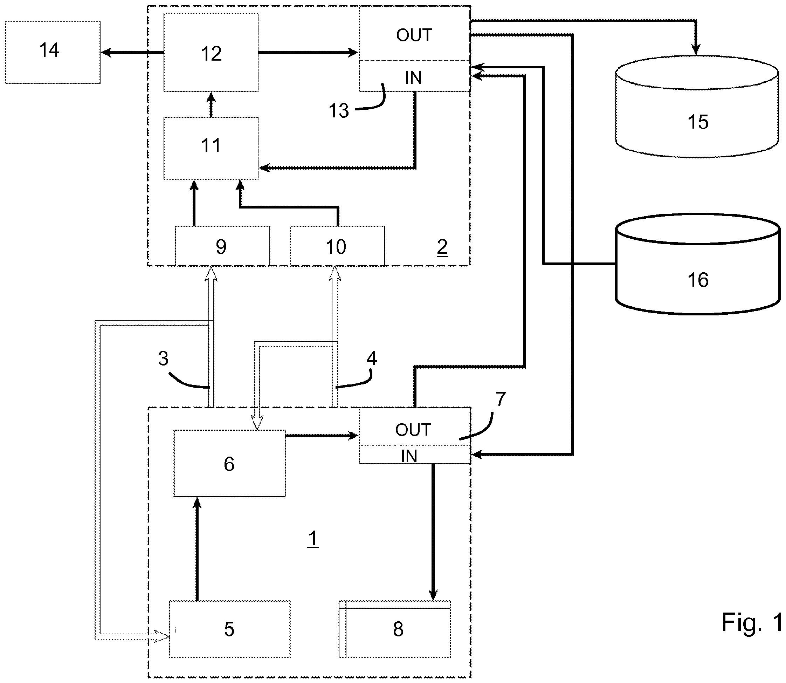

Fig. 1 zeigt ein Blockdiagramm mit einem System aus einem Elektromotor 1 und einer Endprüfanlage 2, wobei in Fig. 1 jeweils die hier relevantesten Komponenten eingezeichnet sind. Der Elektromotor wird mit der Endprüfanlage verbunden, um eine Prüfung des Elektromotors vor dessen Auslieferung durchzuführen. Dabei können zum einen Sensoren des Elektromotors kalibriert werden, zum anderen werden Parameterdaten an einen Parameterspeicher übergeben.

Der Elektromotor 1 ist Bestandteil eines Ventilators und erzeugt beim Betrieb Schwingungen, was durch Pfeil 3 dargestellt ist, und eine Drehzahl, was durch den Pfeil 4 dargestellt ist. Die Schwingungen 3 werden durch einen (internen) Schwingungssensor 5 des Elektromotors in mindestens einer Richtung gemessen. Der Schwingungssensor 5 ist ein Beispiel für einen Sensor, wie er bei dem erfindungsgemäßen Verfahren zum Einsatz kommen kann. Die durch den Schwingungssensor 5 ermittelten Messwerte werden an einen Prozessor 6 übergeben, der beispielsweise durch einen Mikrocontroller gebildet ist. Dieser Prozessor 6 kann beispielsweise eine Analog-Digital-Wandlung vornehmen und/oder das Erfassen der Messwerte steuern. Damit kann der Prozessor 6 aus den Messwerten Schwingungswerte ermitteln. Darüber hinaus ist der Prozessor 6 zum Bestimmen der aktuellen Drehzahl ausgebildet.

Der Prozessor 6 ist mit einer Schnittstelle 7 und einem (internen) Speicher verbunden, der als nicht-flüchtiger Speicher ausgebildet ist und als Parameterspeicher 8 fungiert. Die Schnittstelle 7 stellt eine Kommunikationsverbindung zu der Prüfanlage 2 dar. Über einen Ausgang OUT der Schnittstelle 7 können Informationen an die Prüfanlage 2 gesandt werden, über einen Eingang IN der Schnittstelle 7 können Informationen von der Prüfanlage 2 empfangen werden, wobei der Eingangskanal und der Ausgangskanal nicht zwingend getrennt voneinander implementiert sein müssen, sondern auch eine gemeinsame Kommunikationsleitung nutzen können, beispielsweise unter Verwendung eines Busses.

Die Prüfanlage 2 umfasst mindestens einen Prüfsensor 9, einen Drehzahlsensor 10, eine Datenerfassungseinheit 11, einen Prozessor 12 und eine Schnittstelle 13. Die Prüfanlage ist unter anderem dazu ausgebildet, eine Kalibrierung des Schwingungssensors 5 unter Verwendung des mindestens einen Prüfsensors 9 durchzuführen. Der mindestens eine Prüfsensor 9 ist dazu ausgebildet, die Schwingungen 3 des Elektromotors 1 zu messen. Dazu ist der mindestens eine Prüfsensor 9 mit dem Elektromotor schwingungstechnisch gekoppelt. Der Drehzahlsensor 10 misst die aktuelle Drehzahl 4 des Elektromotors 1. Sowohl der/die Prüfsensor/en 9 als auch der Drehzahlsensor 10 übergeben gemessene Messwerte an die Datenerfassungseinheit 11, die wiederum Informationen an den Prozessor 12 weitergeben kann. Der Prozessor 12 ist mit einer Datenausgabeeinheit 14 verbunden, über die beispielsweise eine Wuchtanzeige erfolgen kann oder Ergebnisse einer Endprüfung ausgegeben werden können. Der Prozessor ist zudem mit der Schnittstelle 13 verbunden, die wie Schnittstelle 7 einen Eingang IN und einen Ausgang OUT umfasst. Der Eingang IN der Schnittstelle 13 ist mit dem Ausgang OUT der Schnittstelle 7 kommunizierend verbunden, während der Ausgang OUT der Schnittstelle 13 mit dem Eingang IN der Schnittstelle 7 kommunizierend verbunden ist. Ergänzend ist der Eingang IN der Schnittstelle 13 mit der Datenerfassungseinheit 11 verbunden und der Ausgang OUT der Schnittstelle 13 mit einer Datenbank 15, die eine Motordatenbank zur Speicherung von Betriebsparametern des Elektromotors 1 darstellt. Gleichzeitig ist der Eingang IN der Schnittstelle 13 mit einer PPS-Datenbank 16 (Produkt-Planung und Steuerung) verbunden, die Informationen über den Aufbau und die Beschaffenheit des Elektromotors 1 speichert.

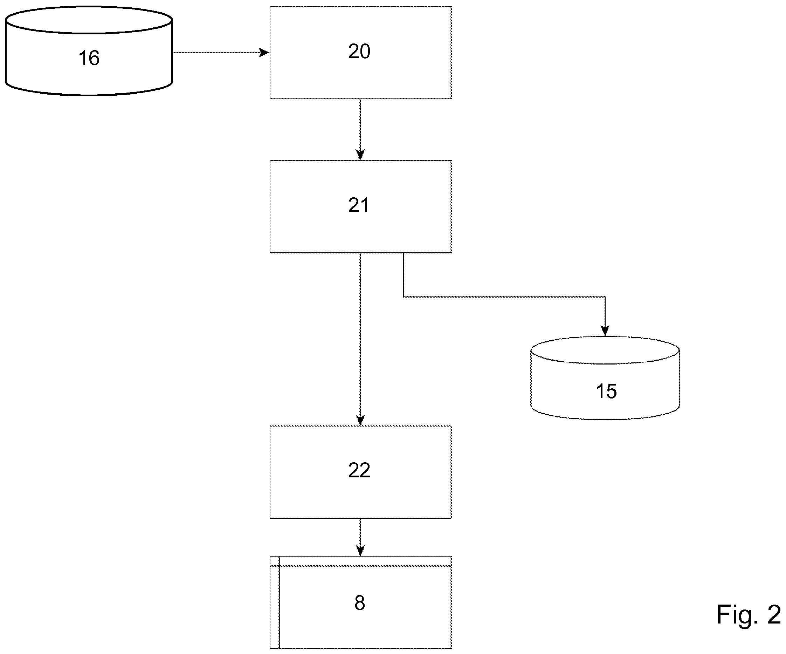

Fig. 2 zeigt ein Ablaufdiagramm, das beispielhaft ein Speichern von Parameterdaten in dem Parameterspeicher 8 zeigt. In Schritt 20 werden systeminterne Kenndaten des Ventilators bzw. dessen Motors bzw. dessen Bauteile aus der PPS-Datenbank 16 geladen. Diese Parameterdaten können umfassen:
- Schwerpunkte und Massen (z.B. Rotor, Lüfterrad, Statorbuchse)
- Lageranstellkräfte
- Axialschub-Drehzahl-Kennlinie (durch Lüfterrad verursacht)
- Magnetische Anziehung zwischen Stator und Rotor (Radialkraft)
- Kenndaten der Lager und dessen Befettung, gegebenenfalls inklusive Fertigungsdatum der Lager
- Maximal zulässige Unwucht und/oder tatsächliche Restunwucht aus Endprüfung
- Besonderheiten der Lagerung, beispielsweise Nilosring etc., die Einfluss auf die Abschätzung der Lagerlebensdauer haben
- Geometrische Daten des Elektromotors bzw. des Ventilators
- Zulässige bzw. Standard-Einbaulagen
- Maximal zulässige Drehzahl-Schwingungswert-Wertepaare bzw. -Kennlinie

Diese oder ähnliche Parameterdaten können aus verschiedenen Quellen der PPS-Datenbank 16 stammen. So wäre denkbar, dass einzelne Informationen aus CAD-Datensätzen (Computer Aided Design) stammen. Andere Informationen können aus der technischen Konstruktion oder aus Messungen an einem baugleichen Elektromotor stammen. Zusätzlich können Parameterdaten aus den Kalibrierungsmessungen entstehen und ebenso in Schritt 20 geladen oder gesammelt werden.

In Schritt 21 werden die Parameterdaten, die in Schritt 20 geladen bzw. gesammelt worden sind, zur Parametrisierung an die Schnittstelle 13 übergeben. Von dort aus werden sie an die Datenbank 15 und an die Schnittstelle 7 des Elektromotors 1 übertragen. Die Datenbank 15 kann einen "digitalen Zwilling" des Elektromotors speichern, wobei die Parameterdaten dort als Bestandteil des "digitalen Zwillings" abgelegt sein können. In Schritt 22 werden die Parameterdaten, die an Schnittstelle 7 übertragen worden sind, durch den Elektromotor empfangen und in dem Parameterspeicher 8 abgespeichert.

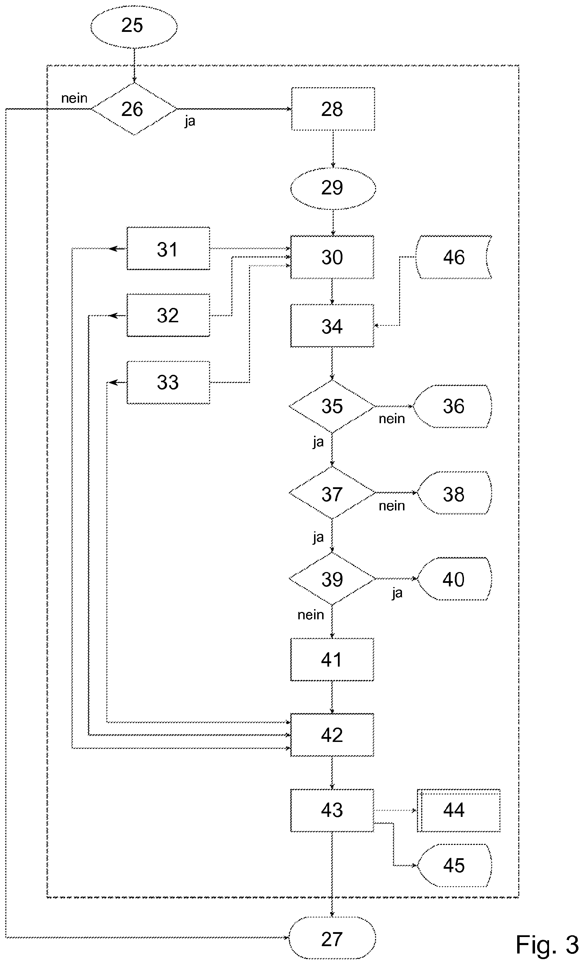

Fig. 3 zeigt ein Ablaufdiagramm eines Ausführungsbeispiels eines erfindungsgemäßen Verfahrens, das diese Parameterdaten nutzt. In Schritt 25 wird eine Versorgungsspannung an den Elektromotor 1 gelegt, so dass die Motorelektronik mit Energie versorgt und hochgefahren wird. In Schritt 26 wird überprüft, ob der Elektromotor das erste Mal nach der Endprüfung in Betrieb genommen wird. Wird diese Frage verneint, wird zu Schritt 27 gewechselt, an dem der Verfahrensablauf endet. Wird die Frage bejaht, beginnt mit Schritt 28 das eigentliche Bewertungsverfahren. Hier wird der Inbetriebnahmelauf gestartet. In Schritt 29 beginnt ein Hochlaufvorgang, bei dem die Drehzahl des Elektromotors in mehreren Drehzahlstufen von einer Drehzahl von Null auf eine Nenndrehzahl erhöht wird.

In Schritt 30 werden Messwerte von Sensoren des Elektromotors gesammelt, die in den Schritten 31, 32 und 33 gemessen werden. In Schritt 31 wird mittels einer Neigungsmesseinheit die räumliche Orientierung des Elektromotors bzw. dessen Welle bestimmt. In Schritt 32 werden mittels eines Schwingungssensors Schwingungen des Elektromotors gemessen und Schwingungswerte bestimmt. In Schritt 33 wird die Drehzahl des Elektromotors ermittelt. Insbesondere die Schritte 32 und 33 können für alle Drehzahlstufen durchgeführt werden, auch wenn das Ablaufdiagramm - der Übersichtlichkeit wegen - lediglich einen Durchlauf zeigt. Das Messen der Einbaulage kann - in den meisten Anwendungsszenarien - lediglich einmalig erfolgen, da sich die Einbaulage nicht ändern dürfte.

In Schritt 34 werden zu den erfassten Messwerten korrespondierende Parameterdaten aus dem Parameterspeicher geladen. Diese Parameterdaten sind im vorliegenden Fall ein zulässiger Bereich einer räumlichen Orientierung des Elektromotors, eine maximal zulässige Unwucht des Elektromotors, eine maximal zulässige Schwingung und Schwingungswerte aus der Endprüfung des Elektromotors. Dies ist durch Feld 46 symbolisiert, das die in dem Parameterspeicher 8 gespeicherten Parameterdaten darstellt.

In Schritt 35 wird die mittels der Neigungsmesseinheit gemessene räumliche Orientierung des Elektromotors mit dem Parameterdatum "zulässiger Bereich der räumlichen Orientierung" verglichen und damit der Messwert der räumlichen Orientierung des Elektromotors bewertet. Liegt die gemessene räumliche Orientierung außerhalb des zulässigen Bereiches, wird in Schritt 36 eine Warnmeldung ausgegeben, wonach die Einbaulage außerhalb des zulässigen Bereichs liegt. Danach kann das Verfahren abgebrochen werden. Liegt die gemessene räumliche Orientierung innerhalb des zulässigen Bereiches, wird zu Schritt 37 gewechselt.

In Schritt 37 werden Wertepaare aus einer Drehzahl und einem dazugehörigen Schwingungswert mit Toleranzgrenzen verglichen, wobei die Toleranzgrenzen durch die zuvor geladenen Parameterdaten definiert sind. Liegt der Schwingungswert außerhalb der Toleranzgrenzen, wird in Schritt 38 hierauf reagiert. Hierbei wird zum einen eine Warnmeldung ausgegeben, dass der Schwingungswert größer als die maximal zulässigen Schwingungen ist. Zum anderen kann eine Drehzahlreduzierung erfolgen, mit der sich die Schwingungen reduzieren sollten. Reduzieren sich die Schwingungen bei einer relativ geringen Drehzahländerung erheblich, so kann auf das Vorliegen einer Resonanzstelle geschlossen werden. In diesem Fall kann mit dem Verfahren prinzipiell fortgefahren werden. Sollte die Drehzahlreduktion keine signifikante Reduktion der Schwingungen ergeben, so kann das Verfahren vollständig abgebrochen werden. Entsprechendes kann erfolgen, wenn der Schwingungswert erheblich über dem maximal zulässigen Schwingungswert liegt.

In Schritt 39 wird ein aktuell gemessener Schwingungswert mit den Schwingungswerten verglichen, die während der Endprüfung des Elektromotors durchgeführt worden sind. Liegen die aktuell gemessenen Schwingungswerte erheblich über den Schwingungswerten aus der Endprüfung, so liegt sehr wahrscheinlich eine Beschädigung oder ein fehlerhafter Einbau des Elektromotors vor. Bei der Bewertung der aktuell gemessenen Schwingungswerte werden dabei die Schwingungen der Einbauumgebung mitberücksichtigt. Hierzu werden Schwingungen bei einer Drehzahl des Elektromotors von Null erfasst und von den Schwingungswerten bei einer Drehzahl ungleich Null abgezogen. Dadurch kann eine Fehlentscheidung aufgrund von Schwingungen aus der Einbauumgebung vermieden werden. Sind die Schwingungswerte aus der Kalibrierungsmessung erheblich überschritten, kann in Schritt 40 angezeigt werden, dass sehr wahrscheinlich ein Transportschaden oder ein Montagefehler vorliegt. Auch in diesem Fall kann die Ausführung des weiteren Verfahrens abgebrochen werden, so dass weiterreichende Beschädigungen des Elektromotors bzw. des Ventilators verhindert werden können.

In Schritt 41 ist dann die Nenndrehzahl des Elektromotors erreicht und der Hochlaufvorgang abgeschlossen. Danach können in Schritt 42 die tatsächlich auf die Lager wirkenden Kräfte berechnet werden. Hierzu werden die in Schritt 31 erfasste räumliche Orientierung, die in Schritt 32 erfassten Schwingungswerte und die in Schritt 33 erfasste Drehzahl verarbeitet. Zusätzlich werden weitere Parameterdaten aus dem Parameterspeicher geladen, die beispielsweise Lageranstellkräfte, geometrische Informationen zu dem Elektromotors, geometrische Informationen zu dem Laufrad, eine Axialschub-Drehzahl-Kennlinie und Informationen zu Massen von Teilen des Elektromotors umfassen können.

Aus den so berechneten tatsächlich wirkenden Kräften wird dann in Schritt 43 die Lagerlebensdauer als Initialwert abgeschätzt. Diese kann als nominelle Lagerlebensdauer L10h angegeben sein. Diese ist in der Norm ISO 281 definiert und gibt die Lebensdauer an, die von 90 % der unter gleichen Betriebsbedingungen geprüften Lagern erreicht wird. Damit steht die nominelle Lebensdauer L10h für eine 10-prozentige Ausfallwahrscheinlichkeit.

In Schritt 44 werden der Initialwert der Lagerlebensdauer sowie Daten, die während des Ablaufs des Verfahrens gewonnen worden sind in einem internen Speicher der Motorelektronik abgespeichert. Des Weiteren wird in Schritt 45 angezeigt, dass Nennbetrieb aufgenommen worden ist. Das Verfahren endet dann in Schritt 27, der den Nennbetrieb des Elektromotors darstellt.

Zusätzlich können die während des Ablaufs des Verfahrens gewonnenen Messwerte und/oder die Ergebnisse der Bewertungen an die Datenbank 15 übertragen werden. So können beispielsweise der Initialwert der nominellen Lebensdauer L10h und Messwerte für die Schwingungen der Einbauumgebung an die Datenbank übertragen werden und den "digitalen Zwilling" ergänzen. Zusätzlich oder alternativ ist auch denkbar, dass die gewonnenen Informationen, beispielsweise in einer Industrie 4.0 Umgebung, an eine Überwachungseinheit gesendet werden, wobei die Überwachungseinheit einen sicheren Betrieb des Elektromotors überwachen würde.

Hinsichtlich weiterer vorteilhafter Ausgestaltungen des erfindungsgemäßen Verfahrens wird zur Vermeidung von Wiederholungen auf den allgemeinen Teil der Beschreibung sowie auf die beigefügten Ansprüche verwiesen.

Schließlich sei ausdrücklich darauf hingewiesen, dass das voranstehend beschriebene Ausführungsbeispiel lediglich zur Erörterung der beanspruchten Lehre dient, diese jedoch nicht auf das Ausführungsbeispiel einschränken.

### Bezugszeichenliste

- 1: Elektromotor
- 2: Endprüfanlage
- 3: Schwingungen
- 4: Drehzahl
- 5: Schwingungssensor
- 6: Prozessor
- 7: Schnittstelle
- 8: Parameterspeicher
- 9: Prüfsensor
- 10: Drehzahlsensor
- 11: Datenerfassungseinheit
- 12: Prozessor
- 13: Schnittstelle
- 14: Datenausgabeeinheit
- 15: Datenbank
- 16: PPS-Datenbank

## Patentansprüche

1. Verfahren zum Bewerten einer Betriebsbereitschaft eines Elektromotors (1), insbesondere eines Elektromotors eines Ventilators, vorzugsweise während einer Erstinbetriebnahme, umfassend die Schritte:
Initiieren (29) eines Hochlaufvorgangs des Elektromotors (1), wobei die Drehzahl während des Hochlaufvorgangs in mehreren Drehzahlstufen geändert wird.
Erzeugen (30) mindestens eines Messwerts durch jeweiliges Messen (31, 32, 33) einer physikalischen Größe mit einem Sensor (5) des Elektromotors (1) bei mindestens einer der Drehzahlstufen,
Laden (34) mindestens eines Parameterdatums aus einem Parameterspeicher (8) des Elektromotors (1), wobei das mindestens eine Parameterdatum zu dem erzeugten mindestens einen Messwert korrespondiert, und
Bewerten (35, 37, 39) des mindestens einen Messwerts für mindestens eine der Drehzahlstufen unter Verwendung des geladenen mindestens einen Parameterdatums.

2. Verfahren nach Anspruch 1, **dadurch gekennzeichnet, dass** der Hochlaufvorgang bei einer unteren Drehzahl beginnt und bis zu einer oberen Drehzahl in Drehzahlstufen erhöht wird, wobei die untere Drehzahl vorzugsweise einer Drehzahl gleich Null - Stillstand des Elektromotors - entspricht und die obere Drehzahl vorzugsweise eine Nenndrehzahl des Elektromotors ist.

3. Verfahren nach Anspruch 1 oder 2, **dadurch gekennzeichnet, dass** vor dem Schritt des Erzeugens des mindestens einen Messwerts überprüft wird, ob die Drehzahl des Elektromotors eine eingestellte Drehzahlstufe erreicht hat.

4. Verfahren nach einem der Ansprüche 1 bis 3, **dadurch gekennzeichnet, dass** bei dem Schritt des Bewertens des mindestens einen Messwerts das Einhalten einer Randbedingung überprüft wird und dass bei nicht erfolgter Einhaltung der Randbedingung eine Warnmeldung ausgegeben und/oder das Verfahren abgebrochen wird.

5. Verfahren nach einem der Ansprüche 1 bis 4, **dadurch gekennzeichnet, dass** zusätzlich eine Lagerlebensdauer abgeschätzt wird, wobei bei der Abschätzung der Lagerlebensdauer mehrere Parameterdaten geladen und/oder mehrere Messwerte gemessen werden.

6. Verfahren nach einem der Ansprüche 1 bis 5, **dadurch gekennzeichnet, dass** die Parameterdaten Referenzwerte und/oder konstruktive Informationen über den Elektromotor und/oder konstruktive Informationen über eine durch den Elektromotor betriebene Last und/oder Kennlinien des Elektromotors und/oder Kennlinien von Komponenten und/oder Informationen über das Betriebsverhalten des Elektromotors umfassen.

7. Verfahren nach einem der Ansprüche 1 bis 6, **dadurch gekennzeichnet, dass** die Schritte des Erzeugens mindestens eines Messwerts, des Ladens mindestens eines Parameterdatums und des Bewertens des mindestens einen Messwerts für jede der Drehzahlstufen durchgeführt werden.

8. Verfahren nach einem der Ansprüche 1 bis 7, **dadurch gekennzeichnet, dass** bei dem Schritt des Erzeugens des mindestens einen Messwerts eine Beschleunigung und/oder eine Geschwindigkeit einer Schwingung des Elektromotors mittels eines Schwingungssensors des Elektromotors gemessen und ein Schwingungswert erzeugt wird, wobei das Erzeugen eines Schwingungswertes bei einer Drehzahl gleich Null - Stillstand des Elektromotors - durchgeführt werden kann, um Schwingungen einer Einbauumgebung des Elektromotors zu erfassen.

9. Verfahren nach Anspruch 8, **dadurch gekennzeichnet, dass** bei dem Schritt des Ladens des mindestens einen Parameterdatums eine maximal zulässige Schwingung geladen wird und in dem Schritt des Bewertens des Messwerts mit dem erzeugten Schwingungswert verglichen wird und/oder
dass bei dem Schritt des Ladens des mindestens einen Parameterdatums ein während einer Kalibriermessung des Elektromotors erzeugter Schwingungswert für eine aktuelle Drehzahl geladen und im Schritt des Bewertens des Messwerts mit dem erzeugten Schwingungswert verglichen wird.

10. Verfahren nach Anspruch 8 oder 9, **dadurch gekennzeichnet, dass** ein erster Schwingungswert während eines Stillstands des Elektromotors und ein zweiter Schwingungswert bei einer von Null verschiedenen Drehzahl bestimmt wird und dass bei Abweichen des zweiten Schwingungswerts abzüglich des ersten Schwingungswertes um ein vorgegebenes Maß von dem während der Kalibrierungsmessung des Elektromotors erzeugten Schwingungswert für die von Null verschiedene Drehzahl für das Vorliegen einer Beschädigung entschieden wird.

11. Verfahren nach einem der Ansprüche 1 bis 10, **dadurch gekennzeichnet, dass** bei dem Schritt des Erzeugens des mindestens einen Messwerts eine räumliche Orientierung des Elektromotors gemessen wird, wobei bei dem Schritt des Ladens des mindestens einen Parameterdatums ein zulässiger Bereich einer räumlichen Orientierung des Elektromotors geladen und im Schritt des Bewertens des Messwerts überprüft werden kann, ob die räumliche Orientierung in dem zulässigen Bereich liegt.

12. Elektromotor (1), der zur Durchführung eines Verfahrens nach einem der Ansprüche 1 bis 11 ausgebildet ist, mit einem Parameterspeicher (8) und einer Schnittstelle (7) zur Übertragung von Parameterdaten, wobei der Parameter-speicher zum Speichern von über die Schnittstelle (7) während eines Parametrier-vorgangs übertragenen Parameterdaten ausgebildet ist.

13. Elektromotor nach Anspruch 12, **dadurch gekennzeichnet, dass** die Parameterdaten einen Schwerpunkt des Elektromotors oder Teile des Elektromotors und/oder eine Masse des Elektromotors oder Teile des Elektromotors und/oder Lageranstellkräfte und/oder Kenndaten des Lagers und/oder eine maximal zulässige Unwucht des Elektromotors und/oder geometrische Daten des Elektromotors und/oder einen zulässigen Bereich räumlicher Orientierungen des Elektromotors und/oder eine maximal zulässige Drehzahl des Elektromotors und/oder eine Kennlinie der magnetischen Anziehung zwischen Stator und Rotor des Elektromotors umfassen.

14. Ventilator mit einem Elektromotor nach Anspruch 12 oder 13 und einem Laufrad, wobei das Laufrad mit einem Rotor des Elektromotors verbunden ist.

15. Ventilator nach Anspruch 14, **dadurch gekennzeichnet, dass** die Parameterdaten eine maximal zulässige Unwucht des Ventilators und/oder geometrische Daten des Laufrads und/oder Informationen über die Ausgestaltung des Laufrads und/oder eine Axialschub-Drehzahlkennlinie umfassen.

## Claims

1. Method for evaluating the operational readiness of an electric motor (1), in particular an electric motor of a fan, preferably during an initial operation, comprising the steps of:
initiating (29) a run-up operation of the electric motor (1), wherein the speed is changed in several speed stages during the run-up operation,
generating (30) at least one measurement value by means of respective measurement (31, 32, 33) of a physical variable using a sensor (5) of the electric motor (1) during at least one of the speed stages,
loading (34) at least one parameter data item from a parameter store (8) of the electric motor (1), wherein the at least one parameter data item corresponds to the at least one measurement value produced, and
evaluating (35, 37, 39) the at least one measurement value for at least one of the speed stages using the loaded at least one parameter data item.

2. Method according to claim 1, **characterised in that** the run-up operation begins at a lower speed and is increased up to a higher speed in speed stages, wherein the lower speed preferably corresponds to a speed equal to zero - stoppage of the electric motor - and the upper speed is preferably a nominal speed of the electric motor.

3. Method according to claim 1 or 2, **characterised in that**, prior to the step of generating the at least one measurement value, it is verified whether the speed of the electric motor has reached an adjusted speed stage.

4. Method according to any one of claims 1 to 3, **characterised in that**, during the step of evaluating the at least one measurement value, the compliance with a peripheral condition is verified and **in that**, when the peripheral condition has not been complied with, a warning message is output and/or the method is interrupted.

5. Method according to any one of claims 1 to 4, **characterised in that** in addition a bearing service-life is estimated, wherein, when the bearing service-life is estimated, a plurality of parameter data are loaded and/or a plurality of measurement values are measured.

6. Method according to any one of claims 1 to 5, **characterised in that** the parameter data comprise reference values and/or structural information items relating to the electric motor and/or structural information items relating to a load operated by the electric motor and/or characteristic lines of the electric motor and/or characteristic lines of components and/or information items relating to the operational behaviour of the electric motor.

7. Method according to any one of claims 1 to 6, **characterised in that** the steps of producing at least one measurement value, loading at least one parameter data item and evaluating the at least one measurement value are carried out for each of the speed stages.

8. Method according to any one of claims 1 to 7, **characterised in that**, during the step of generating the at least one measurement value, an acceleration and/or a speed of a vibration of the electric motor is/are measured using a vibration sensor of the electric motor and a vibration value is generated, wherein the generation of a vibration value can be carried out at a speed equal to zero - stoppage of the electric motor - in order to detect vibrations of an installation environment of the electric motor.

9. Method according to claim 8, **characterised in that**, during the step of loading the at least one parameter data item, a maximum permissible vibration is loaded and in the step of evaluating the measurement value is compared with the generated vibration value, and/or
**in that**, during the step of loading the at least one parameter data item, a vibration value generated during a calibration measurement of the electric motor is loaded for a current speed and during the step of evaluating the measurement value is compared with the generated vibration value.

10. Method according to claim 8 or 9, **characterised in that** a first vibration value is determined during a stoppage of the electric motor and a second vibration value is determined at a speed which differs from zero and **in that**, when the second vibration value minus the first vibration value differs by a predetermined amount from the vibration value generated during the calibration measurement of the electric motor for the speed which differs from zero, the presence of damage is determined.

11. Method according to any one of claims 1 to 10, **characterised in that**, during the step of generating the at least one measurement value, a spatial orientation of the electric motor is measured, wherein, during the step of loading the at least one parameter data item, a reliable range of a spatial orientation of the electric motor is loaded and during the step of evaluating the measurement value it can be verified whether the spatial orientation is located within the permissible range.

12. Electric motor (1) which is constructed to carry out a method according to any one of claims 1 to 11, having a parameter store (8) and an interface (7) for transmitting parameter data, wherein the parameter store is constructed to store parameter data which are transmitted via the interface (7) during a parametrisation operation.

13. Electric motor according to claim 12, **characterised in that** the parameter data comprise a centre of gravity of the electric motor or components of the electric motor and/or a mass of the electric motor or components of the electric motor and/or bearing adjustment forces and/or characteristic data of the bearing and/or a maximum permissible imbalance of the electric motor and/or geometric data of the electric motor and/or a permissible range of spatial orientations of the electric motor and/or a maximum permissible speed of the electric motor and/or a characteristic line of the magnetic attraction between the stator and rotor of the electric motor.

14. Fan having an electric motor according to claim 12 or 13 and an impeller, wherein the impeller is connected to a rotor of the electric motor.

15. Fan according to claim 14, **characterised in that** the parameter data comprise a maximum permissible imbalance of the fan and/or geometric data of the impeller and/or information items relating to the configuration of the impeller and/or an axial thrust/speed characteristic line.

## Revendications

1. Procédé d'évaluation de la capacité opérationnelle d'un moteur électrique (1), plus particulièrement d'un moteur électrique d'un ventilateur, de préférence pendant une première mise en service, comprenant les étapes suivantes :
initiation (29) d'un processus de démarrage du moteur électrique (1), dans lequel la vitesse de rotation pendant le processus de démarrage est modifiée par plusieurs paliers de vitesse de rotation,
génération (30) d'au moins une valeur de mesure par la mesure (31, 32, 33) d'une grandeur physique avec un capteur (5) du moteur électrique (1) dans au moins un des paliers de vitesse de rotation,
chargement (34) d'au moins une donnée de paramètre à partir d'une mémoire de paramètres (8) du moteur électrique (1), dans lequel l'au moins une donnée de paramètre correspond à l'au moins une valeur de mesure générée et
évaluation (35, 37, 39) de l'au moins une valeur de mesure pour au moins un des paliers de vitesse de rotation à l'aide de l'au moins une donnée de paramètre chargée.

2. Procédé selon la revendication 1, **caractérisé en ce que** le processus de démarrage commence à une vitesse de rotation inférieure et est augmenté jusqu'à une vitesse de rotation supérieure par paliers de vitesse de rotation dans lequel la vitesse de rotation inférieure correspond de préférence à une vitesse de rotation égale à zéro - moteur électrique à l'arrêt - et la vitesse de rotation inférieure est de préférence une vitesse de rotation nominale du moteur électrique.

3. Procédé selon la revendication 1 ou 2, **caractérisé en ce que**, avant l'étape de génération de l'au moins une valeur de mesure, il est contrôlé si la vitesse de rotation du moteur électrique a atteint un palier de vitesse de rotation réglé.

4. Procédé selon l'une des revendications 1 à 3, **caractérisé en ce que**, à l'étape d'évaluation de l'au moins une valeur de mesure, le respect d'une condition est contrôlé et **en ce que**, lors d'un non-respect de la condition, une alarme est déclenchée et/ou le procédé est interrompu.

5. Procédé selon l'une des revendications 1 à 4, **caractérisé en ce qu'**une durée de vie de stockage est en outre évaluée, dans lequel, pour l'évaluation de la durée de vie de stockage, plusieurs données de paramètres sont chargées et/ou plusieurs valeurs de mesure sont mesurées.

6. Procédé selon l'une des revendications 1 à 5, **caractérisé en ce que** les données de paramètres comprennent des valeurs de référence et/ou des informations sur la construction du moteur électrique et/ou des informations de construction sur une charge actionnée par le moteur électrique et/ou des courbes caractéristiques du moteur électrique et/ou des courbes caractéristiques de composants et/ou des informations concernant le comportement lors du fonctionnement du moteur électrique.

7. Procédé selon l'une des revendications 1 à 6, **caractérisé en ce que** les étapes de génération d'au moins une valeur de mesure, du chargement d'au moins une donnée de paramètre et de l'évaluation de l'au moins une valeur de mesure sont exécutées pour chacune des vitesses de rotation.

8. Procédé selon l'une des revendications 1 à 7, **caractérisé en ce que**, à l'étape de génération de l'au moins une valeur de mesure, une accélération et/ou une vitesse d'une vibration du moteur électrique est mesurée au moyen d'un capteur de vibrations du moteur électrique et une valeur de vibration est générée, dans lequel la génération d'une valeur de vibration doit être effectuée à une vitesse de rotation égale à zéro - moteur électrique à l'arrêt, afin de mesurer les vibrations d'un environnement de montage du moteur électrique.

9. Procédé selon la revendication 8, **caractérisé en ce que**, à l'étape du chargement de l'au moins une donnée de paramètre, une vibration maximale admissible est chargée et, à l'étape d'évaluation de la valeur de mesure, elle est comparée avec la valeur de vibration générée et/ou
**en ce que**, à l'étape de chargement de l'au moins une donnée de paramètre, une valeur de vibration générée pendant une mesure de calibrage du moteur électrique est chargée pour une vitesse de rotation actuelle et, à l'étape d'évaluation de la valeur de mesure, elle est comparée avec la valeur de vibration générée.

10. Procédé selon la revendication 8 ou 9, **caractérisé en ce qu'**une première valeur de vibration est déterminée pendant l'arrêt du moteur électrique et une deuxième valeur de vibration est déterminée à une vitesse de rotation différente de zéro et **en ce que**, dans le cas d'un écart entre la deuxième valeur de vibration moins la première valeur de vibration d'une grandeur prédéterminée par rapport à la valeur de vibration générée pendant la mesure de calibrage du moteur électrique pour la vitesse de rotation différente de zéro, on en déduit l'existence d'un endommagement.

11. Procédé selon l'une des revendications 1 à 10, **caractérisé en ce que**, à l'étape de génération de l'au moins une valeur de mesure, une orientation spatiale du moteur électrique est mesurée, dans lequel, à l'étape de chargement de l'au moins une donnée de paramètre, une plage admissible d'une orientation spatiale du moteur électrique est chargée et, à l'étape d'évaluation de la valeur de mesure, il peut être contrôlé si l'orientation spatiale se trouve dans la plage admissible.

12. Moteur électrique (1) conçu pour l'exécution d'un procédé selon l'une des revendications 1 à 11, avec une mémoire de paramètres (8) et une interface pour la transmission des données de paramètres, dans lequel la mémoire de paramètre est conçue pour le stockage de données de paramètres transmises par l'intermédiaire de la l'interface (7) pendant un processus de paramétrage.

13. Moteur électrique selon la revendication 12, **caractérisé en ce que** les données de paramètres comprennent un centre de gravité du moteur électrique ou de parties du moteur électrique et/ou une masse du moteur électrique ou de parties du moteur électrique et/ou des forces d'appui de paliers et/ou des données caractéristiques du palier et/ou un déséquilibre maximal admissible du moteur électrique et/ou des données géométriques du moteur électrique et/ou une plage admissible d'orientations spatiales du moteur électrique et/ou une vitesse de rotation maximale admissible du moteur électrique et/ou une courbe caractéristique de l'attraction magnétique entre le stator et le rotor du moteur électrique.

14. Ventilateur avec un moteur électrique selon la revendication 12 ou 13 et une roue, dans lequel la roue est reliée avec un rotor du moteur électrique.

15. Ventilateur selon la revendication 14, **caractérisé en ce que** les données de paramètres comprennent un déséquilibre maximal admissible du ventilateur et/ou des données géométriques de la roue et/ou des informations concernant la conception de la roue et/ou une courbe caractéristique poussée axiale - vitesse de rotation.
